Europäisches Patentamt

European Patent Office

Office européen des brevets

(19)

(11) Publication number: **0 237 280**
**A2**

# (12) EUROPEAN PATENT APPLICATION

(21) Application number: **87301930.1**

(22) Date of filing: **05.03.87**

(51) Int. Cl.[4]: **H 01 L 43/06**

(30) Priority: **07.03.86 JP 49769/86**

(43) Date of publication of application:
**16.09.87 Bulletin 87/38**

(84) Designated Contracting States: **DE GB**

(71) Applicant: **SEIKO INSTRUMENTS INC.**
**31-1, Kameido 6-chome Koto-ku**
**Tokyo (JP)**

(72) Inventor: **Namiki, Masayuki**
**31-1, Kameido 6-chome**
**Koto-ku Tokyo (JP)**

**Kamiya, Masaaki**
**31-1, Kameido 6-chome**
**Koto-ku Tokyo (JP)**

**Goda, Masanori**
**31-1, Kameido 6-chome**
**Koto-ku Tokyo (JP)**

(74) Representative: **Miller, Joseph et al**
**J. MILLER & CO. Lincoln House 296-302 High Holborn**
**London WC1V 7JH (GB)**

(54) **Magnetic sensor.**

(57) A magnetic sensor comprising at least one Hall device (1,2) which is formed on the crystal surface (100) of a silicon single crystal chip (0), characterised in that the or each Hall device (1,2) is arranged so that the direction of current flow between its electrodes (101,102 or 201,202) is substantially parallel to the direction $\bar{1}00$ or the direction 010 on the crystal surface (100).

FIG. 2.

Bundesdruckerei Berlin

# Description

## "MAGNETIC SENSOR"

This invention relates to a magnetic sensor and, although it is not so restricted, it relates more particularly to a magnetic sensor adapted for use in a brushless direct current motor or in a magnetic position detecting device.

As a result of the miniaturization and actuation at low voltage of brushless direct current motors and of position detecting devices, a demand has arisen for a highly sensitive magnetic sensor.

A highly sensitive magnetic sensor employing Hall devices was originally made of semiconductor materials such as GaAs, InSb or the like, which have highly responsive characteristics.

However, in manufacturing a single chip magnetic sensor by utilizing the above-mentioned materials, it is difficult to integrate comparators and other logic circuits in addition to the Hall devices onto the single chip.

In recent years, a Hall device magnetic sensor employing a silicon single crystal has been developed because this type makes it easy to integrate a single chip. In particular, a P-silicon single crystal substrate having a crystal surface (100) has preferably been used as a standard material since it is easy to manufacture it. However, such a Hall device formed on a silicon single crystal still has the following problem.

A silicon single crystal has a large piezo-resistance effect and also has anisotropy. The piezo-resistance effect is the phenomenon that resistance is generated in a device formed on the semiconductor chip when the semiconductor chip is subjected to stress. The piezo-resistance effect causes an offset voltage to be generated at the output terminals of the Hall devices on the silicon chip. The offset voltage is generated at the output terminals even when magnetic fields are not applied to the sensor. A silicon chip Hall device has a high offset voltage, and thus gives rise to errors in detection. Chip mounting (e.g. by diebonding or moulding) is thought to be an external source of the stress. Provided that the magnetic sensitivity of a Hall device is 20 mV/KGauss, a detection error of 50 Gauss occurs when a 1 mV offset voltage is generated by the piezo-resistance effect. Usually, there is not less than 100 Gauss variation in the magnetic sensitivity at 30°C ⌐ 100°C.

According, therefore, to the present invention, there is provided a magnetic sensor comprising at least one Hall device which is formed on the crystal surface of a silicon single crystal chip, characterised in that the or each Hall device is arranged so that the direction of current flow between its electrodes is substantially parallel to the direction [$\bar{1}$00] or the direction [010] on the crystal surface

Preferably, the sensor has a plurality of the said Hall devices.

Preferably, the direction of current flow of each Hall device is at right angles to that of another Hall device.

Control means may be provided for maintaining predetermined output terminals of the Hall devices at substantially the same voltage value. Thus the control means may comprise a comparator which receives input signals from the said output terminals and which transmits output signals to the gate of an n-channel transistor which is connected to an electrode of a said Hall device.

Means may be provided for maintaining the voltage of an electrode of one Hall device somewhat higher than ground voltage.

An electrode of each Hall device may be connected to a common voltage source by way of means which ensure that any potential difference between the said electrodes is maintained substantially constant.

The invention is illustrated, merely by way of example, in the accompanying drawings, in which:-

Figure 1 is a plan view of a magnetic sensor according to the present invention,

Figure 2 is a block diagram showing another embodiment of a magnetic sensor according to the present invention together with its electrical connections;

Figure 3 is a graph illustrating the operation of the magnetic sensor of Figure 2 when magnetic fields are present;

Figure 4 is a graph illustrating the operation of the magnetic sensor of Figure 2 when no magnetic fields are present; and

Figure 5 is a block diagram showing yet another embodiment of a magnetic sensor according to the present invention.

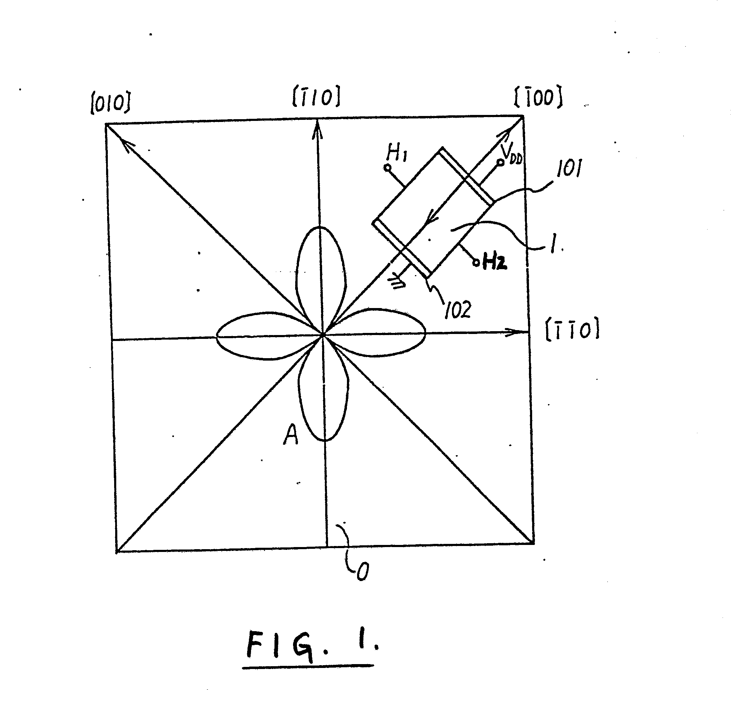

In Figure 1 the reference numeral 0 indicates a P-silicon single crystal chip having a crystal surface (100). The reference numeral 1 denotes a Hall device which is formed on the chip surface and which is constituted, for example, by a MOS type Hall device. Other devices constituting parts of the magnetic sensor are not shown since they are not directly related to the present invention. The reference numerals 101 and 102 denote electric current driven electrodes of the Hall device 1, the electrodes 101, 102 being respectively grounded to $V_{DD}$ and to the ground potential by way of resistors or the like (not shown). Reference characters $H_1$ and $H_2$ denote the Hall voltage output terminals of the Hall device 1, the voltages of the output terminals $H_1$, $H_2$ being mutually opposite to the applied magnetic fields. The voltage which is generated between the two terminals $H_1$, $H_2$ when magnetic fields are not applied is the offset voltage. The electric current driven electrodes 101 and 102 are disposed so that the direction of the driving electric current, which flows between the electrodes 101 and 102, is approximately parallel to the direction [$\bar{1}$00] or the direction [010] on the crystal surface(100).(In order to simplify the drawing, the case in which the direction of flow is approximately parallel to the direction [010] is omitted in Figure 1).

The piezo-resistance effect of a single crystal substrate has anisotropy. The curved line A of Figure 1 shows the distribution of the piezo-resistance coefficient on the surface of the P-silicon crystal (100). As is evident from Figure 1, the piezo-resistance coefficient is large in the directions [ $\overline{11}$0] and [ $\overline{1}$10] but is small in the directions [ $\overline{1}$00] and [010]. However, the Hall device 1 is disposed on the crystal surface(100) so that the driving electric current of the Hall device flows parallel to the direction where the piezo-resistance coefficient is low. Consequently, the piezo-resistance is reduced and the offset voltage is made small.

Generally, the cleavage plane of a semiconductor chip is parallel to the direction [ $\overline{11}$0] or the direction [ $\overline{1}$10] Therefore, scribing is generally conducted in one of these directions and the Hall device is generally disposed parallel to one of these directions [ $\overline{11}$0 or $\overline{1}$10]. In the case of the present invention, however, the Hall device or devices are disposed at 45 degrees with respect to these usual directions.

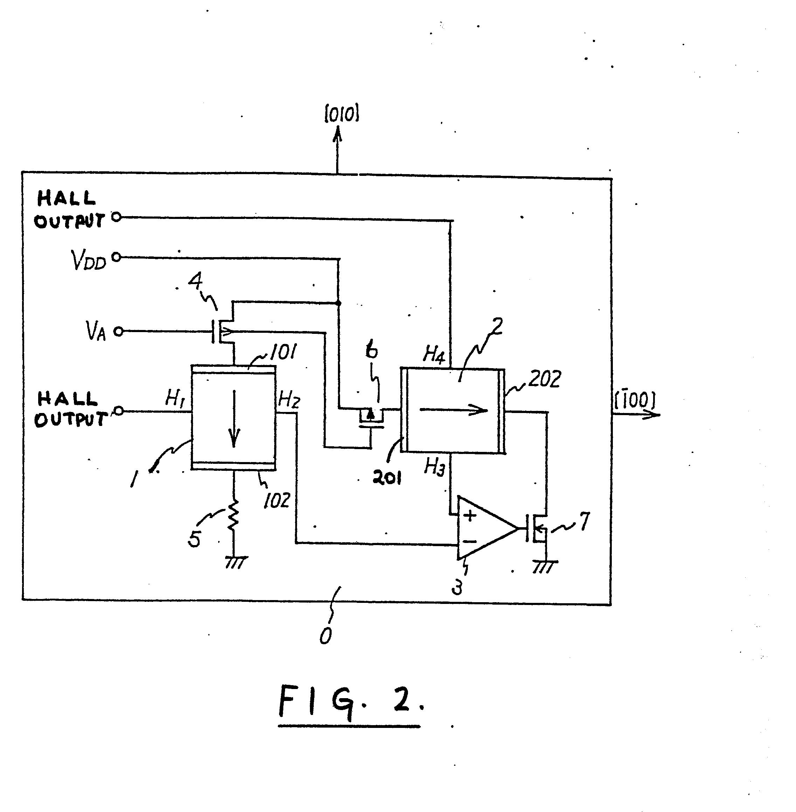

Figure 2 shows an embodiment of a magnetic sensor according to the present invention wherein two Hall devices 1, 2 having almost the same characteristics are formed on one chip and wherein the direction of the driving electric current of each Hall device 1, 2 is disposed parallel to the direction [ $\overline{1}$00] or the direction [010]. The magnetic sensor shown in Figure 2 has the effect of minimizing the offset voltages, adding up all the Hall voltages and compensating for each offset voltage.

In Figure 2, the reference numeral 0 denotes a semiconductor chip made of a P-silicon single crystal substrate (100), the reference numerals 1 and 2 denoting the Hall devices having almost the same characteristics. The Hall devices 1, 2 which are formed on the semiconductor chip 0 may, for example, be MOS type Hall devices. The reference numerals 101 and 102 indicate the electric current driven electrodes on the Hall device 1. The electrode 101 is, as a drain, connected to $V_{DD}$ by way of a p-channel transistor 4, and the electrode 102 is, as a source, connected to $V_{SS}$ (ground) by way of a resistor 5. The driving electric current of the Hall device 1, as shown by the arrow, flows from the electrode 101 to the electrode 102. Similarly, the reference numerals 201 and 202 denote the electric current driven electrodes of the Hall device 2. The electrode 201 (drain) is connected to $V_{DD}$ by way of a p-channel transistor 6, and the electrode 202 (source) is connected to $V_{SS}$ (ground) by way of a n-channel transistor 7. The driving electric current of the Hall device 2, as shown by the arrow flows from the electrode 201 to the electrode 202.

As is obvious from Figure 2, the driving current of the Hall device 1 flows almost parallel to the direction [010], and the driving electric current of the Hall device 2 flows almost parallel to the direction [ $\overline{1}$00]. Accordingly, in either case, the offset voltage is minimized. As is also shown in Figure 2, the driving electric current flowing in the Hall device 1 and the driving electric current flowing in the Hall device 2 cross at right angles. That is, the electrodes of the Hall devices are disposed so that the driving electric currents intersect perpendicularly to each other. As a result, the offset voltages of the Hall devices are cancelled by each other. Reference characters $H_1$ and $H_2$ denote the Hall output terminals of the Hall device 1 and have voltage variations which are opposite in direction to each other. Reference characters $H_3$ and $H_4$ denote the output terminals of the Hall device 2 and have voltage variations which are opposite in direction to each other. Reference numeral 3 denotes a comparator. The comparator 3 has input signals from the Hall output terminals $H_2$ and $H_3$, which show voltage variations opposite to each other, and it has an output signal which is directed to the gate of an n-channel transistor 7.

The comparator 3 compares the voltage of the Hall output $H_2$ of the Hall device 1 with that of the Hall output $H_3$ of the Hall device 2 and then drives the gate of the n-channel transistor 7 so that the voltage of the Hall output $H_3$ is made equal to the voltage of the Hall output $H_2$. As a result of the changes of the resistance between the channels caused by changes in the gate voltage of the n-channel transistor 7, the voltages of the driving current electrodes 201 and 202 of the Hall device 2 are correspondingly changed. Consequently, the voltage of the Hall output $H_3$ is adjusted so that it becomes equal to the voltage of the Hall output $H_2$.

The resistance 5 is provided for the purpose of maintaining the voltage of the electric current driven elecrode 102 of the Hall device 1 a little higher than the ground voltage and for the purpose of operating the above stated voltage adjustment function regardless of the Hall output amount of $H_2$ and $H_3$. Therefore, by making the distance between the electric current driven electrode 101 and the Hall output terminals $H_1$, $H_2$ of the Hall device 1 shorter than the corresponding distance of the Hall device 2, the resistance 5 can be omitted.

The p-channel transistors 4 and 6 have the function of supplying the same constant electric current to the Hall devices 1 and 2, respectively. That is, the difference of the electric potential between the electric current driving electrode 101 of the Hall device 1 and that of the electrode 201 of the Hall device 2 is kept constant and equal by the transistors 4, 6.

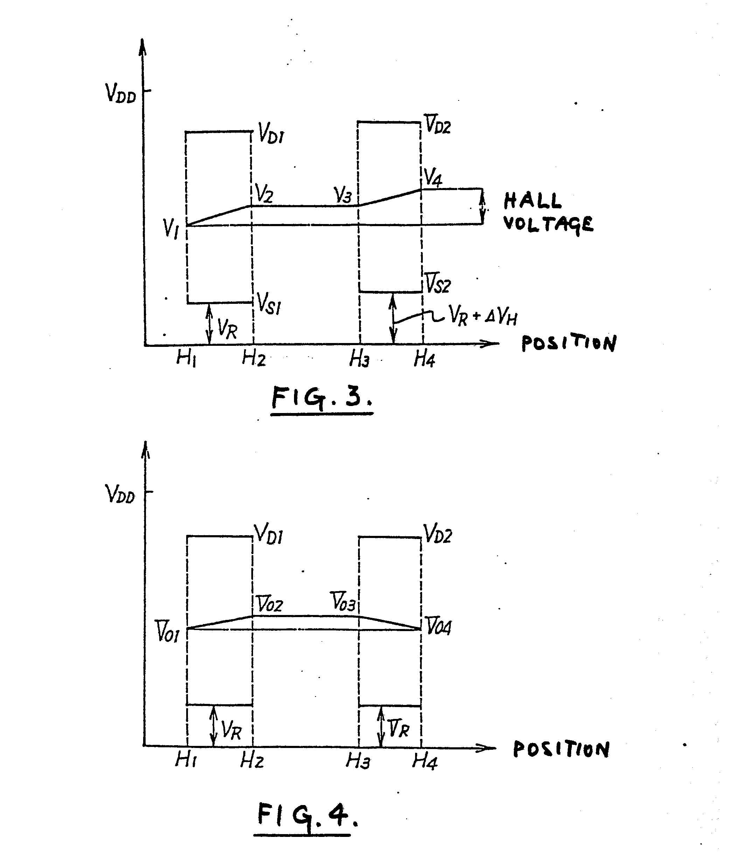

Figure 3 shows the operation of the magnetic sensor of Figure 2 when magnetic fields have been applied thereto. When the output voltages of the Hall devices 1 and 2 are changed by the magnetic fields, the circuit in Figure 2, which is made up of the comparator 3 and the other components, operates and equalizes the voltage $V_2$ of the Hall output $H_2$ with the voltage $V_3$ of the Hall output $H_3$ Then, the voltage $V_{D2}$ of the electric current driven terminal 201 and the voltage $V_{S2}$ of the electric current driven terminal 202 of the Hall device 2 are maintained at a fixed potential difference, while the voltages are shifted upward by $\Delta V_H$, or the amount of the Hall voltage of the Hall device 1, namely $(V_2 - V_1)$ relatively to the voltages $V_{D1}$ and $V_{S1}$ of the current driven terminals 101 and 102 of the Hall device 1, respectively. Accordingly, the total Hall voltage $V_H$ of the magnetic sensor (i.e. the difference of the electric potential between the Hall output terminals $H_1$ and $H_4$) is $(V_2 - V_1)$ plus $(V_4 - V_3)$ or the output of the Hall device 2, which is expressed as,

$$V_H = (V_2 - V_1) + (V_4 - V_3) = 2\Delta V_H$$

That is, the Hall voltages of the two Hall devices are added up together.

Figure 4 shows the operation of the magnetic sensor of Figure 2 when no magnetic fields are present. The offset voltage $(V_{02} - V_{01})$ is generated by the piezo-resistance effect in accordance with the stress applied to the Hall device 1 of the magnetic sensor. Similarly, the offset voltage $(V_{04} - V_{03})$ is generated at the Hall device 2. In Figure 4, the amount of the offset voltage is shown in an exaggerated form. Actually, it is several mV. The electric current directions of the Hall devices 1 and 2 are parallel to the directions [010] and [$\bar{1}00$] respectively. Therefore, the piezo-resistance is low, and the offset voltage is minimized.

The piezo-resistance effect of a semiconductor chip or the stress to cause this effect has anisotropy. By disposing the electric current driven electrodes of the Hall device 1 and the Hall device 2 so that the directions of their driving electric current cross at right angles to each other, the anisotropy is made use of. Thus the offset voltage of the Hall device 1 $(V_{02} - V_{01})$ and the offset voltage of the Hall device 2 $(V_{04} - V_{03})$ to have opposite polarities, though they have approximately the same absolute value. Therefore, both the offset voltages are added by the above mentioned function of the comparator 3 and the other components, and cancel or counterbalance each other. Consequently, the total offset voltage of the magnetic sensor (i.e. the difference of the electric potential between the Hall output terminal $H_1$ and the Hall output terminal $H_4$ at the time that magnetic fields are not applied to the sensor) can be further decreased.

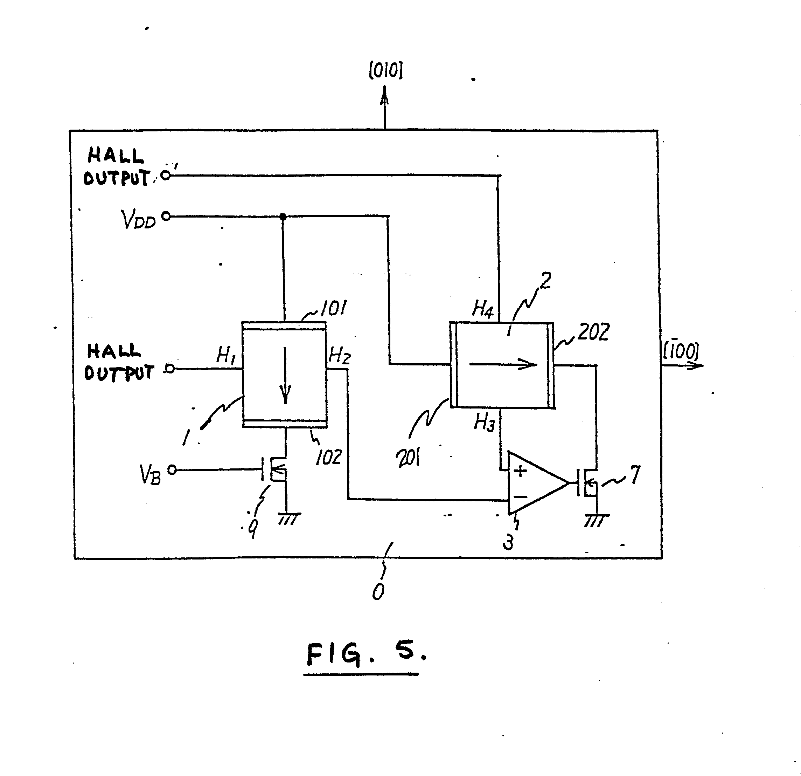

Figure 5 shows another embodiment of the present invention in which the circuit structure of the magnetic sensor of Figure 2 is simplified. Parts of the embodiment of Figure 5 which correspond to those of Figure 2 are given the same reference numerals. Unlike the embodiment of Figure 2, however, in the construction of Figure 5 it is not necessary to vary the voltages of the electric current driven electrodes 201 and 202 of the Hall device 2 at once for the purpose of adding up the Hall voltages generated at each Hall device. In the construction of Figure 5, it is intended that only the voltage of the electric current driven electrode 202 of the Hall device 2 is changed so that the voltages of the Hall outputs $H_2$ and $H_3$ can be made equal. Generally, every Hall voltage is extremely small as compared with the voltage applied between the current driven electrodes 201 and 202. Therefore, the magnetic sensitivity of the Hall device 2 can be thought to be the same as that of the Hall device 1, even if the voltage of the current driven electrode 202 fluctuates by an amount comparable to a Hall voltage. In the above case also, the total Hall voltage output which is twice that of each Hall voltage can be obtained. An n-channel transistor 9, in which a voltage $V_B$ is applied to the gate thereof, works similarly to the resistor 5 of Figure 2.

In the embodiment of Figure 5, the current direction of the Hall device 1 is parallel to the direction [010], and that of the Hall device 2 is parallel to the direction [$\bar{1}00$]. That is, the offset voltage is minimized in both Hall devices.

Further in the embodiment of Figure 5, the Hall devices 1 and 2 are disposed so that the driving electric currents of the two devices cross at right angles. As a result, it is confirmed that the anisotropy of the piezo-resistance effect or of the applied stress cancels the offset voltage generated at each Hall device.

As will be appreciated, the present invention is not limited to the provision of two Hall devices but may, if desired, employ more than two Hall devices.

The magnetic sensor of the present invention decreases the offset voltage, since the direction of the driving electric current of the or each Hall device is disposed in accordance with the direction where the piezo-resistance effect of the chip is minimized. Accordingly, a magnetic sensor can be obtained of substantially improved accuracy.

## Claims

1. A magnetic sensor comprising at least one Hall device (1,2) which is formed on the crystal surface (100) of a silicon single crystal chip (0), characterised in that the or each Hall device (1,2) is arranged so that the direction of current flow between its electrodes (101,102 or 201,202) is substantially parallel to the direction $\bar{1}00$ or the direction 010 on the crystal surface (100).

2. A magnetic sensor as claimed in claim 1 characterised in that there are a plurality of the said Hall devices (1,2).

3. A magnetic sensor as claimed in claim 2 characterised in that the direction of current flow of each Hall device is at right angles to that of another Hall device.

4. A magnetic sensor as claimed in claim 2 or 3 characterised by control means (3,7) for maintaining predetermined output terminals ($H_2$, $H_3$) of the Hall devices (1,2) at substantially the same voltage value.

5. A magnetic sensor as claimed in claim 4 characterised in that the control means (3,7) comprises a comparator (3) which receives input signals from the said output terminals ($H_2$, $H_3$) and which transmits output signals to the gate of an n-channel transistor (7) which is connected to an electrode (202) of a said Hall device (2).

6. A magnetic sensor as claimed in claim 4 or 5 characterised in that means (5) are provided for maintaining the voltage of an electrode (102) of one Hall device (1) somewhat higher than ground voltage.

7. A magnetic sensor as claimed in any of claims 2-6 characterised in that an electrode (101,02) of each Hall device (1,2) is connected to a common voltage source ($V_{DD}$) by way of means (4,6) which ensure that any potential difference between the said electrodes (101,102) is maintained substantially constant.

8. A magnetic sensor having at least one Hall device (1) which is formed on the crystal surface (100) of a silicon single crystal chip (0) and which is made up of a first and a second Hall output terminal ($H_1$, $H_2$) whose voltages are mutually opposite to those of the applied magnetic fields, and two electric current driven electrodes (101,102) disposed on the crystal surface (100) so that each direction of the driving electric current flow is approximately parallel to the direction [ $\bar{1}$00] or [010].

FIG. 1.

HALL

[010]

$V_{DD}$

$V_A$

101

HALL

$H_1$

$H_2$

1

6

$H_4$

2

202

201

$H_3$

[100]

5

102

3

7

0

# FIG. 2.

0237280

FIG. 3.

FIG. 4.

FIG. 5.